(19) Europäisches Patentamt
European Patent Office
Office européen des brevets

(11) **EP 0 715 266 B1**

(12) **EUROPÄISCHE PATENTSCHRIFT**

(45) Veröffentlichungstag und Bekanntmachung des Hinweises auf die Patenterteilung:
**21.07.1999 Patentblatt 1999/29**

(51) Int Cl.6: **G06F 17/50**, G06F 17/16, G06F 19/00

(21) Anmeldenummer: **95118590.9**

(22) Anmeldetag: **25.11.1995**

(54) **Verfahren zur Initialisierung und Aktualisierung eines Netzmodells**

Method for initializing and updating a network model

Procédé pour l'initialisation et la mise à jour d'un modèle de réseau

(84) Benannte Vertragsstaaten:
**CH DE ES FR GB LI NL SE**

(30) Priorität: **02.12.1994 DE 4442963**

(43) Veröffentlichungstag der Anmeldung:
**05.06.1996 Patentblatt 1996/23**

(73) Patentinhaber: **ABB PATENT GmbH**
**68309 Mannheim (DE)**

(72) Erfinder: **Küssel, Reinhard**
**D-69198 Schriesheim (DE)**

(74) Vertreter: **Rupprecht, Klaus, Dipl.-Ing. et al**
**c/o ABB Patent GmbH,**
**Postfach 10 03 51**
**68128 Mannheim (DE)**

(56) Entgegenhaltungen:
• **TINNEY W F ET AL: "SPARSE VECTOR METHODS" IEEE TRANSACTIONS ON POWER APPARATUS AND SYSTEMS, Bd. 104, Nr. 2, 1.Februar 1985, Seiten 295-301, XP000560551**
• **BETANCOURT : "an efficient heuristic ordering algorithm for partial matrix refactorization" IEEE TRANSACTIONS ON POWER SYSTEMS., Bd. 3, Nr. 3, August 1988, NEW YORK US, Seiten 1181-1187, XP002067731**

**Beschreibung**

Die Erfindung bezieht sich auf ein Verfahren zur Initialisierung und Aktualisierung eines Netzmodells, wobei die Netztopologie in Form eines Netzgraphen gebildet wird.

Das Netzmodell kann sich auf Netzwerke unterschiedlichster Art beziehen, z.B. auf elektrische Netze, Gasnetze oder Nachrichtennetze. Nachstehend wird jedoch zur Vereinfachung stets von einem elektrischen Energieversorgungsnetz gesprochen.

Zur Überwachung und Führung elektrischer Netze ist die Kenntnis und Darstellung des topologischen Netzzustandes sowie die Verfolgung der Netzspannung von grundlegender Bedeutung. In den Leitrechnern von Netzführungssystemen werden deshalb topologische Netzmodelle als Prozeßabbilder des zu führenden Übertragungs- oder Verteilnetzes aufgrund statischer Informationen, den Topologie-Daten des Netzes initialisiert und gehalten und aufgrund von ferngemeldeten Schaltermeldungen und Meßwerten (dynamische Informationen) fortlaufend aktualisiert.

Die topologischen Netzmodelle werden für unterschiedliche Zwecke verwendet, z. B. zur graphischen Darstellung des aktuellen Netzzustandes, vorzugsweise durch Einfärbung von Teilen des dargestellten Netzes, wie z.B. beschrieben von W. Grein et al. in "Dynamic Network Colouring", Proceedings of the Eighth Power Systems Computation Conference (PSCC), Helsinki, 19-24 August 1984, Seiten 489 bis 496. Auch als Auskunftsfunktion für globale Verriegelungen, z.B. Schalten auf Erde, oder als Grundlage für Berechnungen. Solche typischen Berechnungen können sich auf einen konsistenten Netzzustand (State Estimation) oder simulierten Netzzustand (Lastflußberechnung) beziehen. Weiterhin gibt es separate Berechnungsfunktionen zur Bestimmung von lokalen Feldtopologien.

Bekannte Verfahren zur Initialisierung und Aktualisierung beruhen auf Algorithmen für Graphen oder spärlichen Adjazenz-Matrizen. Diese Verfahren machen es erforderlich, um den Netzzusammenhang zu ermitteln (Initialisierung), den Graphen des Netzes zu durchsuchen und für jede Komponente einen Spannbaum zu bestimmen. Für große Netze bedeutet dies einen erheblichen Aufwand. Deshalb wird bei einer Schalteränderung versucht, nur die wirklich notwendigen Änderungen (Update) an den Datenstrukturen, die den Netzgraphen oder die spärliche Adjazenzmatrix beschreiben, durchzuführen. Die Bestimmung dieser notwendigen Änderungen kann je nach Netzänderung sehr aufwendig sein. Das Verhältnis von Update zu Initialisierung ist für merkliche Änderungen deshalb in der Größenordnung von 1:10. Im Störungsfall laufen in das Leitsystem eine Vielzahl von Schaltermeldungen ein, die sequentiell von der Topologiefunktion verarbeitet werden müssen. Um den Leitrechner in kritischen Situation nicht mit einer fortlaufenden sequentiellen Verarbeitung topologischer Updates zu überlasten, werden Überlastverfahren eingesetzt, die je nach Situation einen Topologie-Update oder eine Topologie-Initialisierung veranlassen. Alle bisher bekannten Update-Verfahren sind aufwendig, komplex und im mathematischen Sinne nicht abgeschlossen und deshalb fehleranfällig. Aufgrund der Komplexität sind die entwickelten Programmpakete sehr umfangreich sowie die damit verbundene Programmpflege und die Einarbeitung neuer Mitarbeiter in die Anwendung diese Programme sehr aufwendig.

Auf dem Gebiet der Sparse-Vektor-Verfahren und -Matrix-Verfahren sind Algorithmen entwickelt worden, die auch für große elektrische Netze im Rahmen von Netzberechnungen einsetzbar sind. Solche Verfahren sind z.B. beschrieben von V. Brandwajn et al. in "Sparse Vector Methods", IEEE Transactions on Power Apparatus and Systems, Vol. PAS-104, No. 4, February 1985, Seiten 295 bis 301. In dieser Veröffentlichung sind auch Begriffe wie Netzgraph oder Pfad-Tabelle erläutert, die in dieser Beschreibung verwendet werden. Die von Brandwajn et al. beschriebenen Berechnungsverfahren setzen eine Netztopologie bereits als vorhanden voraus. Eine Untersuchung zu Anwendungsmöglichkeiten solcher Verfahren zur Topologiebestimmung ist nicht bekannt.

Der Erfindung liegt die Aufgabe zugrunde, ein Verfahren zur Bestimmung der Netztopologie anzugeben, das eine vergleichsweise wenig aufwendige und schnell durchführbare Initialisierung und Aktualisierung eines Netzmodells ermöglicht.

Diese Aufgabe wird durch ein Verfahren zur Initialisierung und Aktualisierung eines Netzmodells gelöst, das die im Anspruch 1 angegebenen Verfahrensschritte aufweist.

Vorteilhafte Ausgestaltungen sind in weiteren Ansprüchen angegeben und der unten stehenden Erläuterung der Erfindung anhand von Beispielen zu entnehmen.

Das erfindungsgemäße Verfahren ermöglicht eine um Größenordnungen schnellere Initialisierung oder Aktualisierung eines Topologiemodells als bekannte Verfahren. Außerdem ist die Aktualisierungs-(Update-)Zeit weitgehend unabhängig von der Netzgröße.

Gemäß einer vorteilhaften Ausgestaltung wird mit einer topologischen Adresse gearbeitet, die die Dateneingabe vereinfacht, und die es ermöglicht, lokale topologische Funktionen, z.B. Feldtopologien in die Netztopologieberechnung zu integrieren. Meßwerte werden dabei auch als topologische Objekte modelliert, wodurch sich die Dateneingabe vereinfacht und eine exakte Beschreibung auch solcher Netzkonfigurationen möglich ist, bei denen bisher zusätzliche Pseudo-Netzelemente vorzusehen sind.

Netzberechnungen, die auf der modellierten Netztopologie basieren können durch Anwendung des erfindungsgemäßen Verfahrens wesentlich beschleunigt werden, weil notwendige Datenstrukturen und Verarbeitungsschritte schon in dem vorgeschlagenen Verfahren enthalten sind. Neue Impulse und Aspekte ergeben sich auch für Programme wie die (n-1)-Ausfallrechnung und die topologische Beobachtbarkeitsanalyse. Alle diese Programme haben die Auswertung von Topologievarianten des Netzes gemeinsam. Sie profitieren von dem schnellen Update-Verfahren. Deshalb werden für alle Aufgabenstellungen, bei denen Auswirkungen von Netzänderungen sehr schnell festgestellt werden müssen, wesentliche Verbesserungen erwartet. Das können z.B. Topologieverfahren für Nachrichtennetze oder auch Optimierungsverfahren mit Hilfe von Network-Flow Algorithmen sein.

Zur Erläuterung der Erfindung herangezogene Zeichnungsfiguren sind nachstehend aufgelistet.

Es zeigen:

Fig. 1      Stationen und EVU-Stationen,
Fig. 2      Aufbau eines Feldes in einer EVU-Station,
Fig. 3      Adressentransformation,
Fig. 4      Meßwertzuordnung,
Fig. 5      Beispielgraph,
Fig. 6      Terminal-Adjazenz-Matrix und deren LDU-Zerlegung,
Fig. 7      Initialisierung der oberen Dreiecksmatrix,
Fig. 8      Ganzzahlig initialisierte obere Dreiecksmatrix,
Fig. 9      Pfad-Tabelle und Pfad-Graph (Beispiel),
Fig. 10     Mathematische Formulierung von Initialisierung und Update,
Fig. 11     Ganzzahlig aktualisierte obere Dreiecksmatrix,
Fig. 12     Pfad-Tabelle und Pfad-Graph für modifizierten Beispielgraphen,
Fig. 13     Knoten-Zweig-Netz,
Fig. 14     Ableitung der Knoten-Admittanz-Matrix,
Fig. 15     Testgraphen für Leistungsmessung,
Fig. 16     Fiktive Zweige in Abhängigkeit der Netzgröße und des Vermaschungsgrads,
Fig. 17     CPU-Zeit zum Aufbau der statischen Topologie (Testbeispiel),
Fig. 18     CPU-Zeit zur Initialisierung der statischen Topologie (Testbeispiel),
Fig. 19     CPU-Zeit für die Aktualisierung (Testbeispiel).

Die unten stehenden Beispiele zur Erläuterung des Verfahrens basieren auf der nachstehenden vorteilhaften Definition einer externen und internen topologischen Adresse für elektrische Übertragungs- und Verteilnetze. Diese Definition vereinfacht die Dateneingabe und ermöglicht es, lokale topologische Funktionen (Feldtopologieberechnung) in die Netztopologieberechnung zu integrieren.

Elektrische Netze gleich welcher Spannungsebene können durch Endpunkte (Terminals) und deren Verbindungen (Zweige) beschrieben werden. Verbindungen sind hierbei impedanzbehaftete Netzelemente wie Leitung, Transformator oder Längsblindleistungselement etc., oder impedanzlose Netzelemente wie Leistungsschalter, Trenner oder Meßwertobjekt. Endpunkte sind externe topologische Adressen im Netz und können Netzelementen wie Sammelschienenabschnitten oder Teilen von Netzelementen z.B. den beiden Enden (Terminals) einer Leitung zugeordnet werden. Für elektrische Übertragungs- und Verteilnetze wird nun folgende topologische Hierarchie definiert:

| 1 | *Station (oder Geographische Station)* |
| 2 | *EVU-Station (oder Spannungsebene)* |
| 3 | *Feld* |
| 4 | *Terminal* |

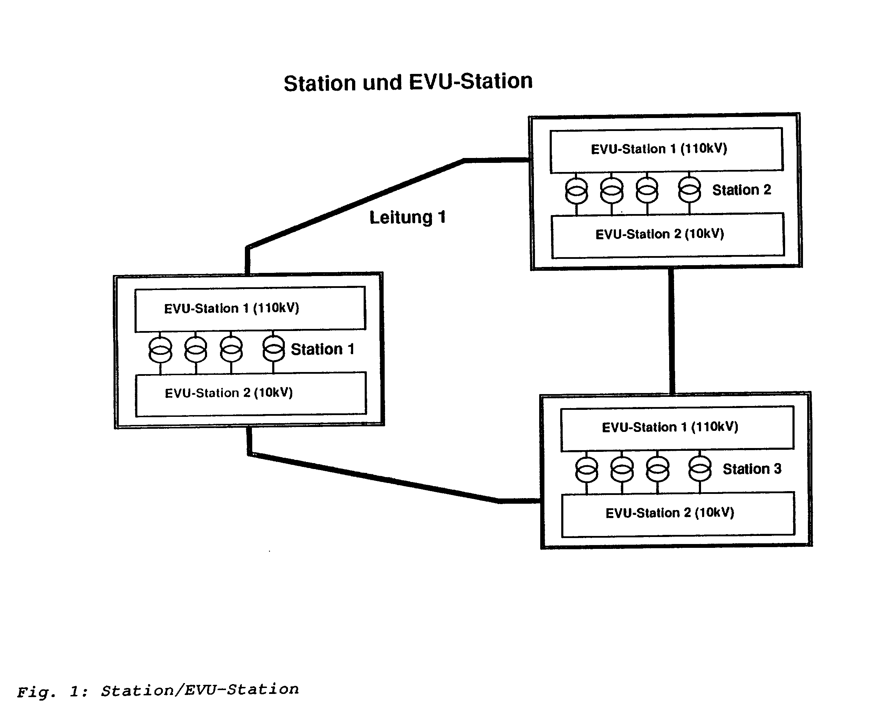

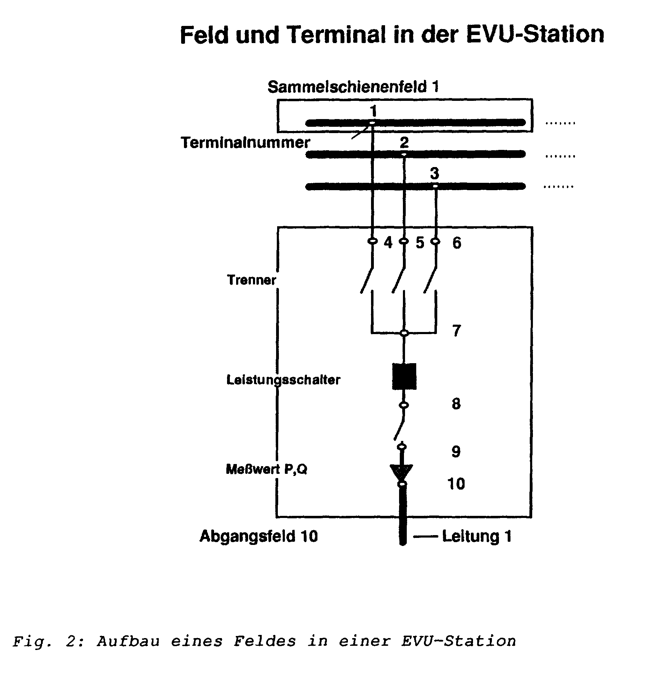

**Fig. 1** zeigt beispielhaft ein Netz, bestehend aus drei Stationen mit jeweils zwei EVU-Stationen. **Fig. 2** zeigt den Aufbau eines Feldes in einer EVU-Station, der sich durch die verwendeten Symbole und die Beschriftung selbst erklärt.

Die externe topologische Adresse ergibt sich dann als Datenstruktur, die für jede dieser Hierarchiestufen einen Identifizierer enthält. Zum Beispiel kann die topologische Adresse des einen Endes der Leitung 1 in Station 1 (siehe **Fig. 1** und **2**) folgendermaßen spezifiziert werden:

| 1 | Station | 1 |

(fortgesetzt)

| 2 | EVU-Station | 1 |
|---|---|---|
| 3 | Feld | 10 |
| 4 | Terminal | 10 |

und folgendermaßen gelesen werden: Die beschriebene topologische Adresse befindet sich in Station 1, innerhalb der Station 1 in der EVU-Station 1, innerhalb der EVU-Station im Feld 10 und innerhalb des Feldes 10 am Terminal 10. **Fig. 1** und **Fig. 2** verdeutlichen die Vorgehensweise.

Für die Grenze jeder Hierarchiestufe gilt, daß diese nicht überlappen dürfen. Das heißt, jedes Terminal darf nur zu einem Feld, jedes Feld nur zu einer EVU-Station und jede EVU-Station nur zu einer Station gehören.

Aus der technologischen Beschreibung der Netztopologie können nun die abstrakten Endpunkte, d.h. die internen topologischen Adressen, des Netzgraphen über die folgend beschriebene Datenstruktur, die von der Datenaufbereitung bereitgestellt wird, sehr einfach und schnell ermittelt werden.

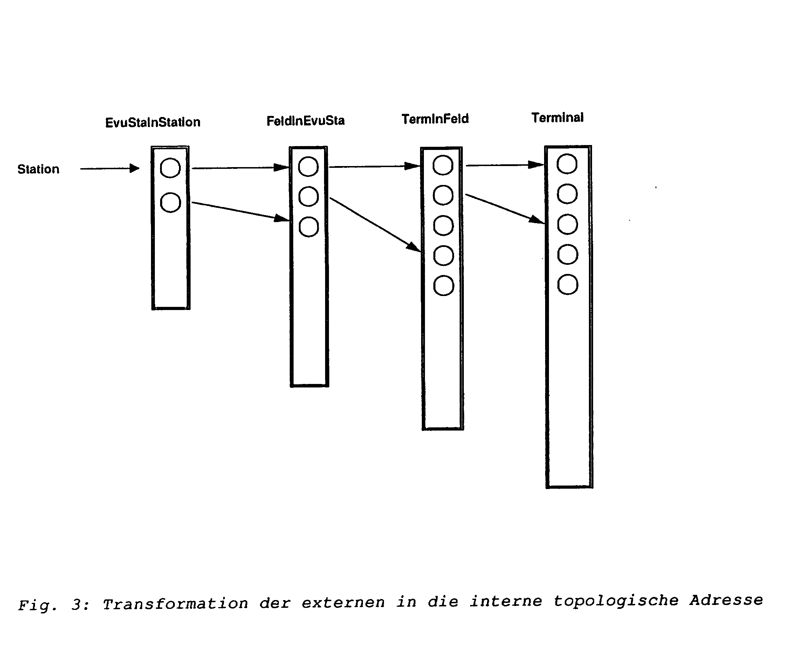

Die Transformation der externen in die interne topologische Adresse ist in **Fig. 3** dargestellt und wird nachstehend beispielhaft beschrieben:

Zwischen *EvuStaInStation[i]* und *EvuStaInStation[i+1]* liegen alle EVU-Stationen der Station i. In der Datenstruktur *EvuStaInStation[]* sind die Identifizierer enthalten, so daß die jeweiligen Teiladressen nicht dicht liegen müssen, sondern durch direkten Vergleich ermittelt werden. Ausnahme ist der Stationsidentifizierer, der als Index für *EvuStaInStation[]* dient. Entsprechend werden die anderen Hierarchiestufen durchlaufen. Der schließlich ermittelte Index der Datenstruktur *Terminal[]* ist die interne topologische Adresse des mit der externen topologischen Adresse spezifizierten Terminalpunktes. Die interne topologische Adresse wird als Index für die Endpunkte (interner Terminalindex) des Netzgraphen verwendet.

Durch die Berücksichtigung der Felder als Teiladresse ist die Ermittlung der Feldtopologie als impliziter Teil der Netztopologie möglich. Hierdurch können die Berechnungsfunktionen zur Ermittlung der lokalen Feldtopologien entfallen.

Auch Meßwerte und Schutzmeldungen lassen sich als topologische Objekte modellieren. Dies vereinfacht die Dateneingabe und ermöglicht die exakte Beschreibung aller Netzkonfigurationen, bei denen bisher zusätzlich Pseudo-Netzelemente vorzusehen waren.

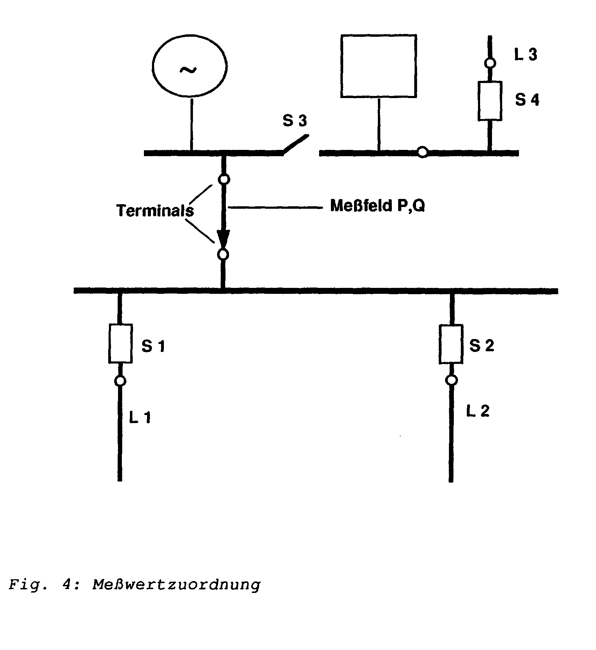

Meßwerte sind ferngemeldete analoge Werte relevanter Prozessgrößen wie Spannung, Strom und Leistung etc., die im Leitrechner angezeigt und auf Grenzwertverletzung überwacht werden. Bei Leitsystemen, die ebenfalls ein Topologiemodell im Leitrechner halten, werden die Meßwerte in Verbindung mit der Netztopologie und den elektrischen Parametern der Netzelemente zur Berechnung eines konsistenten und vollständigen Netz zustandes verwendet (State Estimation). Hierzu müssen Leistungsmeßwerte jeweils den adjazenten impedanzbehafteten Netzelementen und Spannungsmeßwerte den Knoten des Netzmodells zugeordnet werden. Als Knoten bezeichnet man hierbei alle impedanzlos zusammengeschalteten Netzelemente. Knoten werden durch impedanzbehaftete Zweige wie Leitungen und Transformatoren verbunden. Bisher werden bei der Dateneingabe Meßwerte und Netzelemente statisch verknüpft. Dies hat den Nachteil, daß für bestimmte Netzkonfigurationen die Meßwerte anders plaziert werden müssen, als es ihrer tatsächlichen Netzanordnung entspricht. Diesen gravierenden Nachteil vermeidet man, wenn Leistungsmeßwerte als gerichtete impedanzlose Zweige und Spannungsmeßwerte als Objekte mit einer externen topologische Adresse modelliert werden. Die schaltungsabhängige Zuordnung von Meßwert und Netzelement wird dann von der Netztopologie geleistet. Weiterhin wird die Zählpfeilrichtung der Meßwerte direkt von der Orientierung des Meßwertzweiges festgelegt. In **Fig. 4** ist die beschriebene topologische Zuordnung dargestellt. Mit P sind Wirkleistungswerte, mit Q Blindleistungswerte bezeichnet. Je nach Schaltzustand der Schalter S1 bis S4 ergeben sich die in folgender Tabelle aufgelisteten Meßwertzuordnungen und deren Eigenschaften, wobei L1, L2 Leitungen sind.

Tabelle 1:

| Topologische Meßwertzuordnung | | | | | |
|---|---|---|---|---|---|
| S1 | S2 | S3 | S4 | Meßwerteigenschaft | Zuordnung |
| EIN | EIN | EIN | EIN | Summen-Fluß | L1, L2 |
| EIN | EIN | EIN | AUS | Einspeisung | Generator, Last |
| EIN | EIN | AUS | EIN | Einspeisung | Generator |

# EP 0 715 266 B1

Tabelle 1:   (fortgesetzt)

| Topologische Meßwertzuordnung | | | | | |
|---|---|---|---|---|---|
| S1 | S2 | S3 | S4 | Meßwerteigenschaft | Zuordnung |
| EIN | EIN | AUS | AUS | Einspeisung | Generator |
| EIN | AUS | EIN | EIN | Fluß | L1 |
| EIN | AUS | EIN | AUS | Fluß | L1 |
| EIN | AUS | AUS | EIN | Fluß | L1 |
| EIN | AUS | AUS | AUS | Fluß | L1 |
| AUS | EIN | EIN | EIN | Fluß | L2 |
| AUS | EIN | EIN | AUS | Fluß | L2 |
| AUS | EIN | AUS | EIN | Fluß | L2 |
| AUS | EIN | AUS | AUS | Fluß | L2 |
| AUS | AUS | EIN | EIN | - | - |
| AUS | AUS | EIN | AUS | - | - |
| AUS | AUS | AUS | EIN | - | - |
| AUS | AUS | AUS | AUS | - | - |

Während bei der statischen Zuordnung der Meßwert nur einem Netzelement zugeordnet werden kann, ist durch die topologische Zuordnung in allen Fällen eine richtige Zuordnung bei gleichzeitig vereinfachter Dateneingabe möglich. Sinngemäß gilt die gleiche Vorgehensweise für gerichtete Schutzmeldungen wie Erdschlußwischermeldungen und Kurzschlußanzeiger, die für die Lokalisierung von Erdschlüssen oder Kurzschlüssen von der Topologiefunktion ausgewertet werden.

Unter Anwendung der vorstehenden Adressen-Definition erfolgt nachstehend eine ausführliche beispielhafte Beschreibung des erfindungsgemäßen Verfahrens. Alle Verfahrensschritte lassen sich als Rechnerprogramm realisieren und mit Hilfe einer Datenverarbeitungseinrichtung automatisiert durchführen.

## 1. Aufbau der statischen Topologie

Der Graph des betrachteten Netzes besteht aus Endpunkten, sogenannten Terminals, sowie impedanzlosen und impedanzbehafteten Zweigen (Zweitore) wie Schalter, Meßwerten, Verbindern sowie Leitungen, Transformatoren und Längsblindleistungselementen. Weiterhin gibt es zusätzlich Eintore wie Generatoren und Lasten, Spannungsmeßwerte und Erdungsschalter etc., die nur eine topologische Adresse sowie verschiedene Merkmale und Eigenschaften besitzen, die sie auf den zugehörigen Teilgraphen übertragen, wie z.B. *geerdet, spannungslos* oder *unter Spannung.*

Die Datenstruktur des Verfahrens basiert auf einer Terminal-Adjazenz-Matrix, die als vorwärts verkettete Liste abgelegt wird und bei der für jedes Terminal die adjazenten Zweige zugeordnet werden (im folgenden mit *Cst[]* bezeichnet). Für diese symmetrische Matrix, die reine Strukturinformationen enthält, wird eine optimale Eliminationsreihenfolge bestimmt und *Cst[]* um die hierbei zusätzlich entstehenden *Fill In* (fiktive Verbindungszweige) ergänzt. Aufgrund der Ähnlichkeit mit der numerischen LDU-Zerlegung einer Matrix wird im folgenden dieser Schritt *strukturelle Dreiecks- oder LDU-Zerlegung* genannt. Unter LDU-Zerlegung wird die Zerlegung einer Matrix in das Produkt einer Lower-, Diagonal- und einer Upper-Matrix verstanden, wobei die Lower- und Upper-Matrix jeweils Dreiecksmatrizen sind. Um die topologische Eigenschaft der *Fill In* zu verdeutlichen, werden diese im folgenden als fiktive Zweige bezeichnet. Wie im folgenden gezeigt wird, enthält die strukturelle Upper-Matrix (im folgenden mit *Parkett[]* bezeichnet) Information über die Konnektivität des Graphen, die bei Netzänderungen sehr einfach und schnell in *Parkett[]* aktualisiert werden kann.

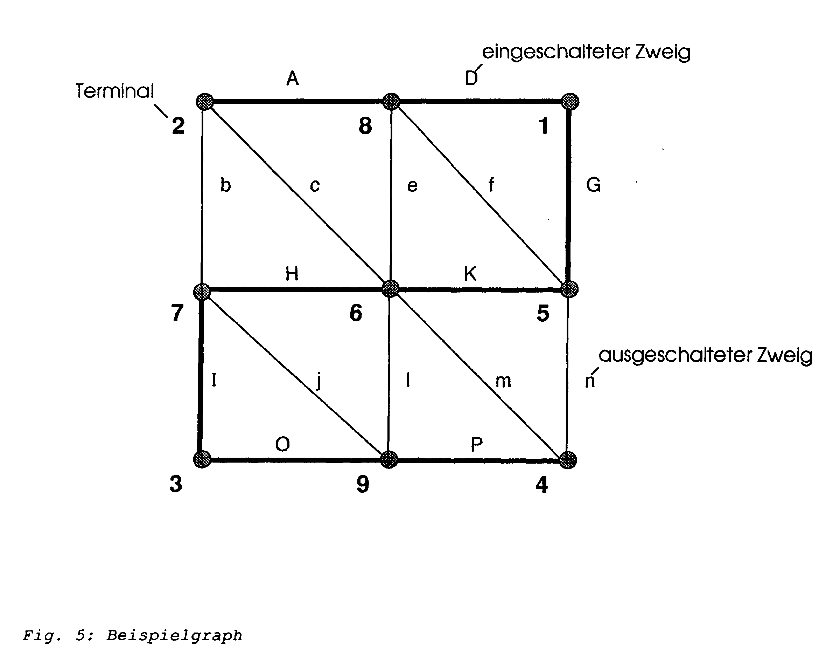

Anhand des in **Fig. 5** gezeigten kleinen Beispielgraphen werden die skizzierten Datenstrukturen verdeutlicht. Alle im Graphen abgebildeten Zweige sind Bestandteil der statischen Topologie. Die mit Großbuchstaben gekennzeichneten Zweige haben den Status *EIN,* die mit Kleinbuchstaben gekennzeichneten den Status *AUS.* In diesem Beispiel sind nur die internen Terminalindizes und Zweigbezeichner aufgeführt. Die Abbildung von externer auf interne Topologieadresse geschieht mit Hilfe der erläuterten Adresshierarchie und kann aus Übersichtsgründen hier einfach weggelassen werden. Ebenfalls ist der Zweigtyp in diesem Beispiel von untergeordneter Bedeutung. Auf eine detaillierte Beschreibung wird deshalb, ohne die Allgemeingültigkeit des Beispiels einzuschränken, verzichtet. Das Beispielnetz mit 9 internen topologischen Adressen und 16 Zweitoren oder Zweigen wird in den folgenden Stufen auf die oben skizzierte Datenstrukturen abgebildet.

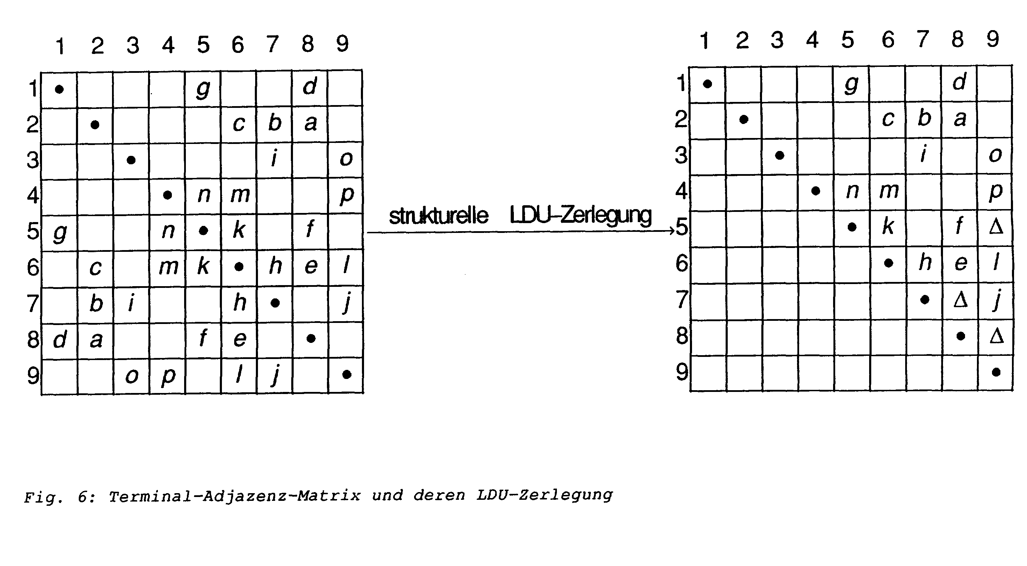

Die Terminal-Adjazenz-Matrix für diesen Graphen und deren LDU-Zerlegung kann nun wie in **Fig. 6** notiert werden. Die Matrixelemente enthalten zur näheren Erläuterung des Algorithmus die Bezeichner der zugehörigen Zweige. Die mit $\Delta$ gekennzeichneten Elemente der Matrix entsprechen den *Fill In,* d.h. den fiktiven Zweigen im Netzwerk. Die Reihenfolge der Terminals ist bei diesem Beispiel zur Vereinfachung schon optimal gewählt. Die interne Programmablage der Terminal-Adjazenz-Matrix geschieht als gedrängt abgespeicherte, vorwärtsverkettete Liste (*Cst[]*), die der LDU-Matrix als eindimensionales Array (*Parkett[]*) von C-Strukturen. Wegen der Struktursymmetrie wird nur die Upper-Matrix abgelegt. Im folgenden wird angenommen das alle Zeilen der Upper-Matrix und alle Elemente dieser Zeilen in optimaler Reihenfolge sortiert sind. Jedes Objekt der verketteten Liste bzw. des Arrays enthält für jedes Nichtdiagonal-Element den Terminalindex des gegenüberliegenden Terminals, den Index in der Zweigliste, den Status des Zweiges und den Zweigtyp.

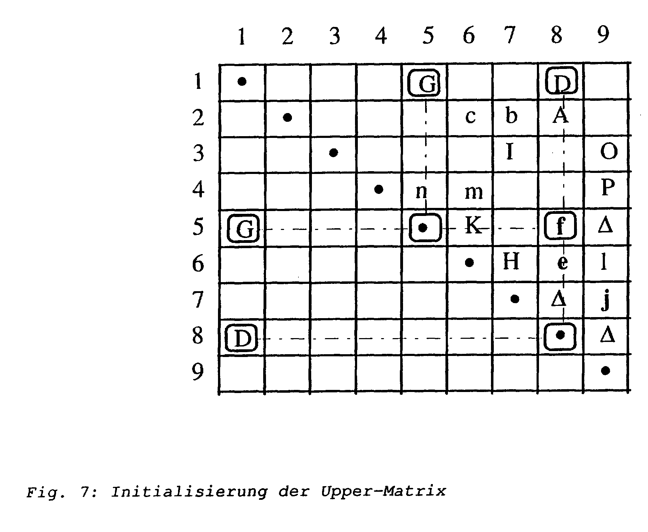

## 2. Initialisierung der Upper-Matrix (vergl. Fig. 7, 8 und 10)

Jedes Element der Upper-Matrix wird aufgrund des zugehörigen Zweigstatus initialisiert:
Status *EIN* $\Rightarrow$ z.B. K = SCHAR_MIN (-128, minimaler Wert eines Byte mit Vorzeichen); Status *AUS*. $\Rightarrow$ 0. Die fiktiven Zweige erhalten den Status *AUS* (0). Für die so initialisierte Matrix wird folgende Prozedur durchgeführt und in Anlehnung an die rein ganzzahligen Operationen *ganzzahlige Initialisierung* genannt. Diese geschieht analog dem Matrix-Produkt aller Zeilen ab dem ersten Nichtdiagonalelement rechts der Diagonalen mit sich selbst:

```
Für alle Zeilen i
   Für alle Zeilenelemente j, k der Zeile i rechts der
   Diagonalen, wobei i=1..n, j=i+1..n, k=j..n und n=Anzahl
   Terminals:
    Falls die zugehörigen Matrixelemente (i,j) und (k,i)
   ungleich 0 sind:
       inkrementiere die Elemente aller zugehörigen
       Schnittpunkte des Zeilen- und Spaltenbruchstückes
       rechts bzw. unterhalb der Diagonalen in der Upper-
       Matrix um 1. Durch die  Struktursymmetrie ist das
       Zeilen-und Spaltenbruchstück identisch


Für die erste Zeile in Fig. 7 ist der erste nichtdiagonale
Schnittpunkt das Matrixelement (5,8) und diesem Element ist
der Zweig f zugeordnet. Dieses Element ist mit 0
initialisiert und erhält den aktuellen Wert von 1.
```

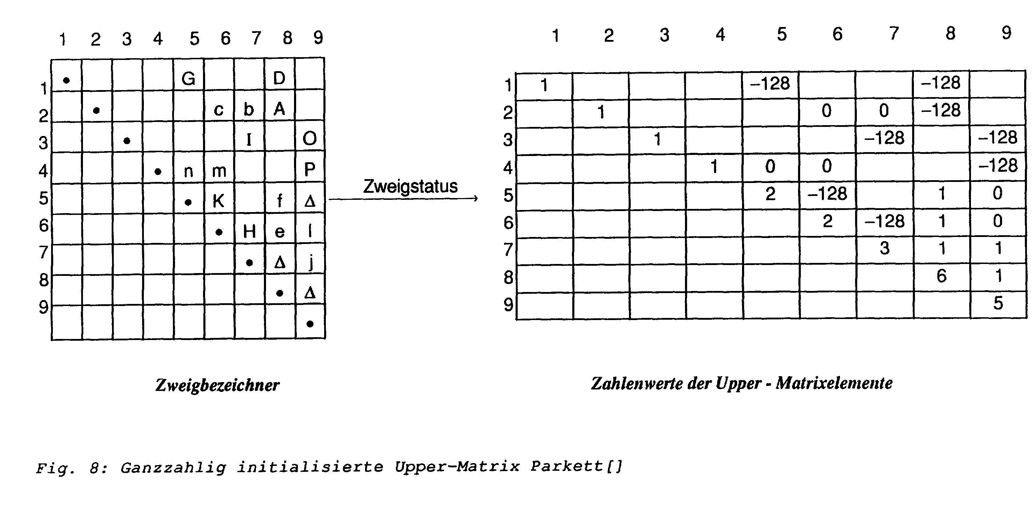

In **Fig. 7** ist dies für die erste Zeile verdeutlicht. Nach dieser ganzzahligen Initialisierung liegt nun die in **Fig. 8** dargestellte Upper-Matrix vor. Normalgedruckte Kleinbuchstaben entsprechen ausgeschalteten Zweigen und haben den Statuszähler 0, normalgedruckte Großbuchstaben entsprechen eingeschalteten Zweigen und haben den Statuszähler SCHAR_MIN + i, wobei i durch die Anzahl der auf dieses Element ausgeführten Inkrementoperationen bestimmt

ist. Die mit Δ gekennzeichneten Elemente der Matrix entsprechen den *Fill In*, d.h. den fiktiven Zweigen im Netzwerk, die entsprechend der aktuellen Topologie aufgrund der ganzzahligen Operationen den Zustand *EIN* oder *AUS* erhalten. Dies entspricht einem Statuszähler 0 oder i, wobei i durch die Anzahl der auf dieses Element ausgeführten Inkrementoperationen bestimmt ist. Die mit fett gedruckten Kleinbuchstaben bezeichneten Zweige haben zwar den aktuellen Status *AUS*, erhalten aber aufgrund der ganzzahligen Operationen den Status eines verbindenden Zweiges und haben ebenfalls einen Statuszähler von i, mit i = Anzahl Inkrementoperationen. Weiterhin kann der Status des Zweiges auch von seinem Typ abhängen, z.B. um spezielle Topologien, wie z.B die Netzbezirkstopologie zu ermitteln. Zur Ermittlung der Netzbezirkstopologie sind alle Transformatoren als trennende Zweige vorzugeben.

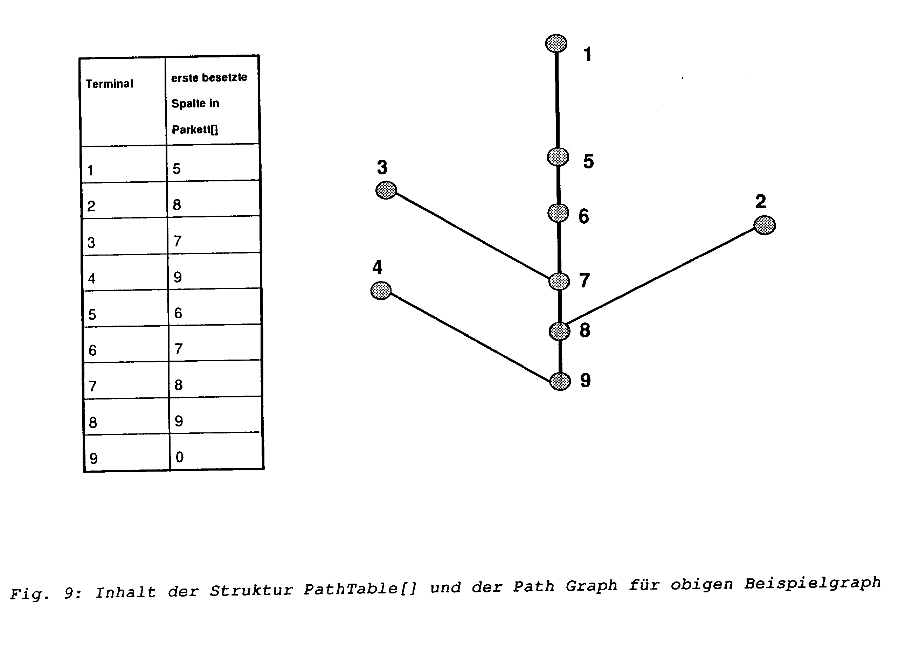

Die Konnektivität des Graphen läßt sich nun sehr einfach aus der *Pfad-Tabelle* (*PathTable[]*) der Upper-Matrix *Parkett[]* ableiten (vergl. **Fig. 9**).

Diese *Pfad-Tabelle* enthält für jeden Terminalindex in *Parkett[]* den *gegenüberliegenden* Terminalindex des ersten adjazenten Zweigs. Diese Tabelle ist neben der Upper-Matrix die zweite wesentliche Datenstruktur dieses Topologieverfahrens. Aus ihr kann die Konnektivität des Netzgraphen leicht ermittelt werden. Diese Tabelle enthält so viele Einträge mit dem Wert 0, wie der Netzgraph in Teilgraphen zerfällt. Die in **Fig. 9** dargestellte *Pfad-Tabelle* kann aus obiger Struktur *Parkett[]* abgeleitet werden. Diese *Pfad-Tabelle* enthält nur eine 0 und der Netzgraph ist deshalb zusammenhängend, wie leicht am *Pfad-Graph* in **Fig. 9** zu erkennen ist.

Durch Zuordnung z.B eines Farbbezugpunktes für die Einfärbung des Netzgraphen oder eines Merkmals zur Kennzeichnung bestimmter Zustände zu einem Entry dieser *Pfad-Tabelle* (i.e. interne topologische Adresse oder Terminalindex), kann nun dem entsprechenden Teilgraphen die zugehörige Farbe oder Eigenschaft zugeordnet werden, indem der *Pfad-Graph* durchlaufen wird.

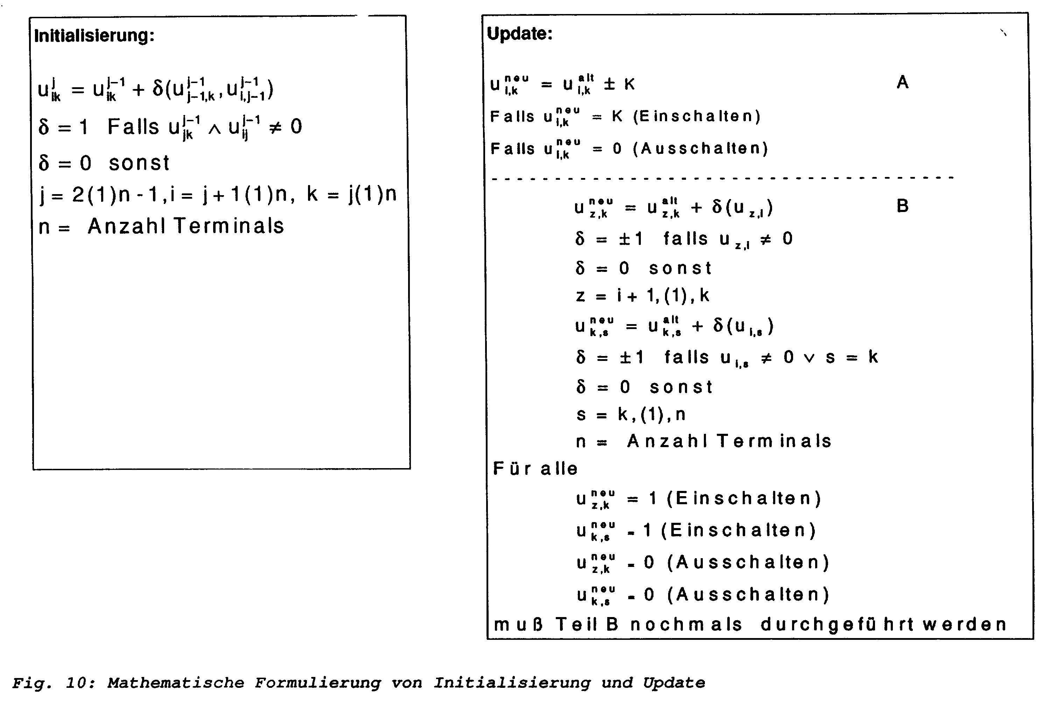

### 3. Update der Netztopologie(vergl. Fig. 10, 11 und 12)

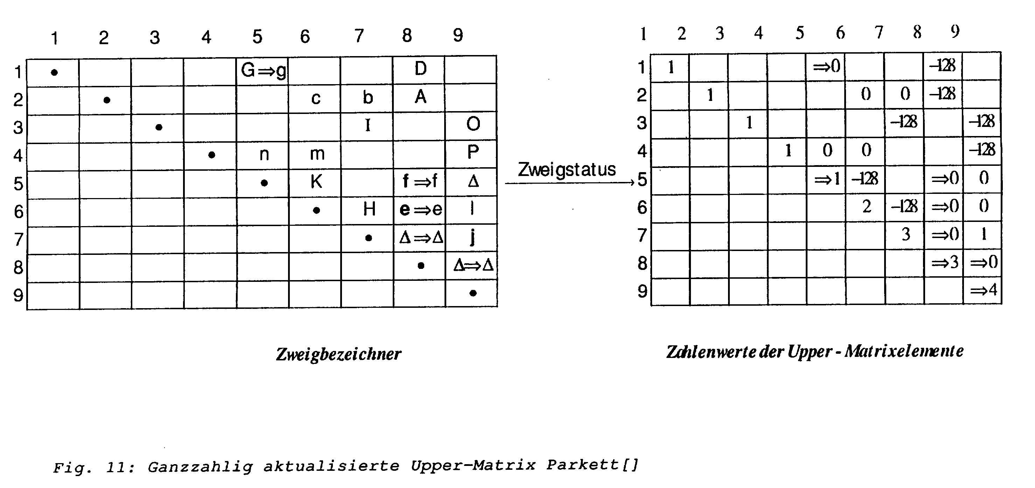

Angenommen im Beispielgraph ändert sich der Status des Zweiges G von *EIN* nach *AUS*. Der ganzahlige Updatealgorithmus ermittelt nun Änderungen für mit ⇒ gekennzeichnete Matrixelemente, wie **Fig. 11** zeigt. Der Algorithmus kann für eine Ausschaltung bzw. Einschaltung eines Zweiges folgendermaßen formuliert werden:

**Ausschaltung eines Zweiges:**

*Subtrahiere vom entsprechenden Element der Upper Matrix die Konstante K. Falls hierdurch dieses Element zu 0 wird[1]:*

*Update AUS:*

   *Für dieses Element:*

      *dekrementiere für alle Schnittpunkte dieses Elementes mit allen anderen Elementen ungleich 0 der zugehörigen Zeile bzw. Spalte rechts bzw. unterhalb der Diagonalen, die entsprechenden Elemente in der Upper-Matrix um 1. Für jedes Element, das hierdurch zu 0 wird, wiederhole Update AUS*

**Einschaltung eines Zweiges:**

*Addiere zum entsprechenden Element der Upper Matrix die Konstante K. Falls hierdurch dieses Element zu K wird[1]:*

*Update Ein:*

   *Für dieses Element:*

      *dekrementiere für alle Schnittpunkte dieses Elementes mit allen anderen Elementen ungleich 0 der zugehörigen Zeile bzw. Spalte rechts bzw. unterhalb der Diagonalen, die entsprechenden Elemente in der Upper-Matrix um 1. Für jedes Element, das hierdurch zu 1 wird, wiederhole Update EIN*

*[1]Nur dann hat die Zustandsänderung einen topologischen Einfluß und die Aktualisierung der Upper-Matrix darf stattfinden*

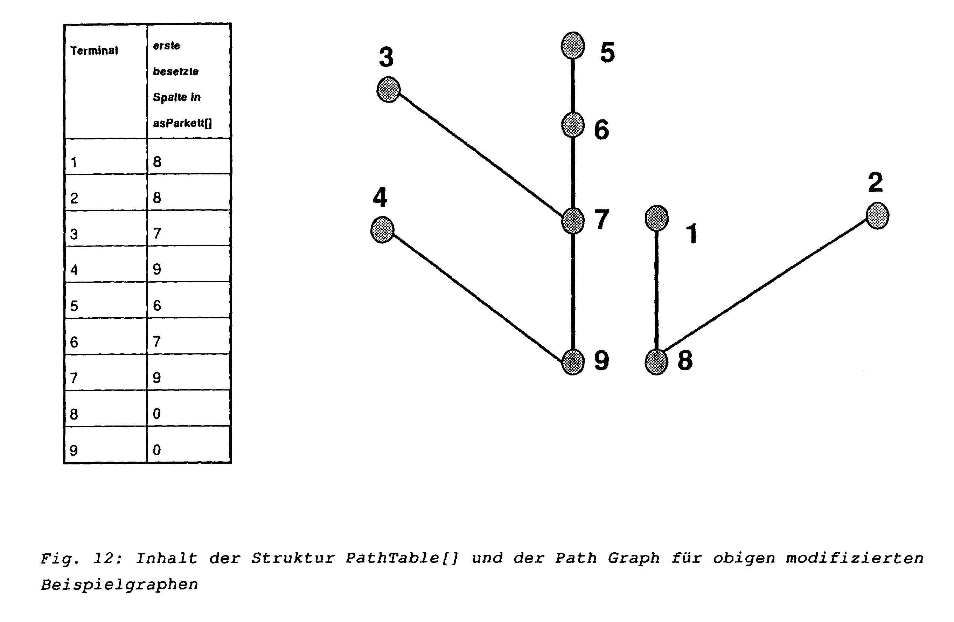

Für dieses Beispiel führt die Dekrementierung des Matrixelementes (8,9) dazu, daß dieses Element den Wert 0 erhält. Daraus folgt, daß die aktualisierte *Pfad-Tabelle* einen weiteren Null-Eintrag erhält, d. h. der Netzgraph zerfällt in zwei Teilgraphen. Die in **Fig. 12** dargestellte *Pfad-Tabelle* läßt sich aus der aktualisierten Struktur *Parkett[]* ermitteln. Es ist an der *Pfad-Tabelle* und am *Pfad-Graph* offensichtlich, daß der Graph in zwei Teilgraphen zerfallen ist. Eine Farbgebung oder die Weitergabe eines Merkmals ist durch die Bearbeitung der *Pfad-Tabelle* nun sehr einfach und sehr schnell möglich.

## 4. Lastflußschnittstelle

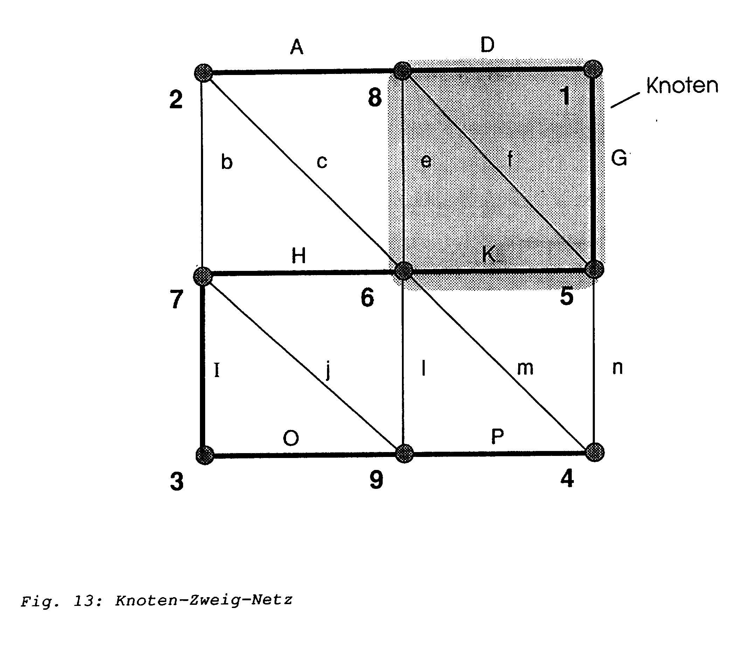

Die Struktur der LDU-Matrix für Lastfluß- oder Kurzschlußberechnungen erhält man in zwei Stufen. In der ersten Stufe werden alle impedanzlosen Zweige, außer den Meßwerten, zu Knoten zusammengefaßt. Anschließend werden die Meßwerte den impedanzbehafteten Netzelementen zugeordnet und in der zweiten Stufe die Meßwerte ebenfalls mit den Knoten verschmolzen. **Fig. 13** zeigt ein Knoten-Zweig-Netz. Unterstellt man, daß die Zweige d,e,f, G,K impedanzlos sind, so kann aus *Parkett[]* unmittelbar die (LD)U-Form der Knotenadmittanzmatrix extrahiert werden. Auf eine Meßwertzuordnung wird in diesem Beispiel verzichtet.

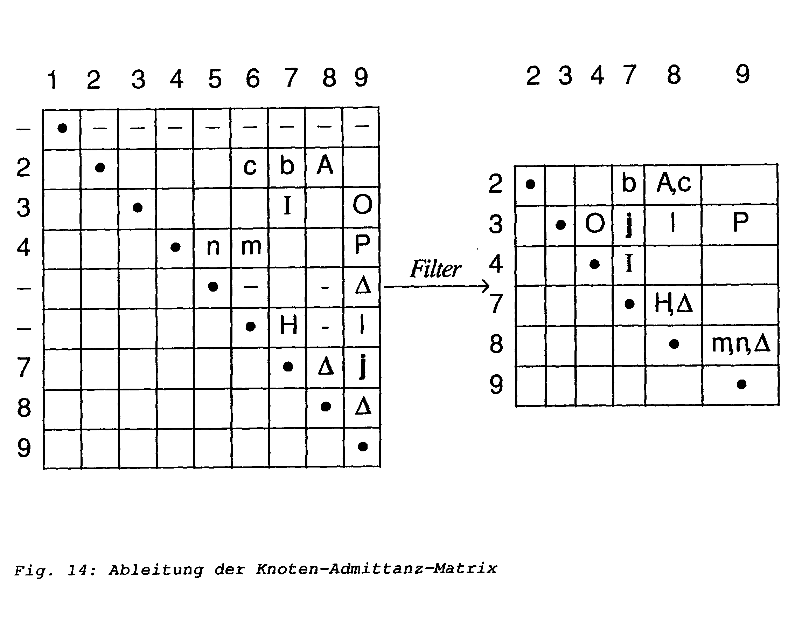

Die Terminals 1,5,6,8 verschmelzen in den Knoten 8, während alle anderen Terminals durch impedanzbehaftete Zweige verbunden sind und deshalb erhalten bleiben. Es ergibt sich also die in **Fig. 14** dargestellte Upper-Form der strukturellen JACOBI- oder Knoten-Admittanz-Matrix.

Die Filter-Funktion eliminiert alle impedanzlosen Zweige und transferiert die betroffenen Zweigenden (Terminals) von impedanzbehafteten Zweigen zu den Terminals mit höherem Index, wie hier z.B. 1,5,6→8. Dies ist somit schon die Struktur der JACO-BI-Matrix (Lastfluß) oder der Knoten-Admittanz-Matrix (Kurzschluß). Die weiteren Schritte einer Lastflußrechnung sind dann einfach durchführbar. Indem die LDU-Zerlegung schon auf der Ebene der Basis-Topologie (Schalter-Terminal) durchgeführt wird, können eine Vielzahl von Programmschritten entfallen. Diese Vereinfachung der Programme verbessert im erheblichem Maße die Rechenzeit und die Fehleranfälligkeit der Berechnungsprogramme wie State-Estimation, Lastfluß und Kurzschluß.

## 5. Testnetze

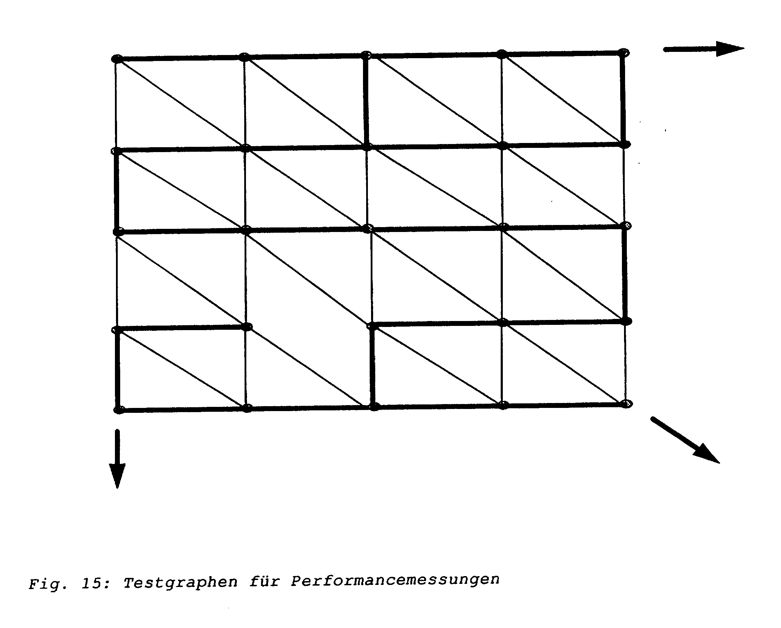

**Fig. 15** zeigt die Form eines generierbaren Netzes, mit dem Performancetests für den Algorithmus durchgeführt wurden. Durch Parametervorgabe kann der Vermaschungsgrad VG des Netzes zwischen 0 und 3 und die Netzgröße beliebig vorgegeben werden. Der Vermaschungsgrad ergibt sich aus (1).

$$VG = \frac{Anzahl\ Zweige}{Anzahl\ Terminals\ \text{-}1} \qquad (1)$$

In elektrischen Übertragungsnetzen und Verteilnetzen variiert der Vermaschungsgrad zwischen 1 und 1,5. Für ein großes reales Verteilnetz ermittelt sich z.B. der zugehörige Vermaschungsgrad VG inklusive der einspeisenden 110kV Stationen und Umspanner folgendermaßen:

| | |
|---|---|
| Anzahl Schalter (ohne Erdungsschalter): | 9683 |
| Anzahl Leitungen: | 2100 |
| Anzahl 110/10kV-Umspanner: | 22 |
| Anzahl 10/0,4KV-Netztrafos: | 1200 |
| Anzahl Zweige: | 13005 |

Mit der Anzahl Terminals von 11.623 ergibt sich ein Vermaschungsgrad von **VG = 1,119.** Das bedeutet, daß die im folgenden vorgelegten Performancezahlen für VG = 1,2 bei großen Verteilnetzen als Obergrenze anzusehen sind.

## 6. Performance

### 6.1. Anzahl fiktiver Zweige über die Netzgröße in Abhängigkeit vom Vermaschungsgrad

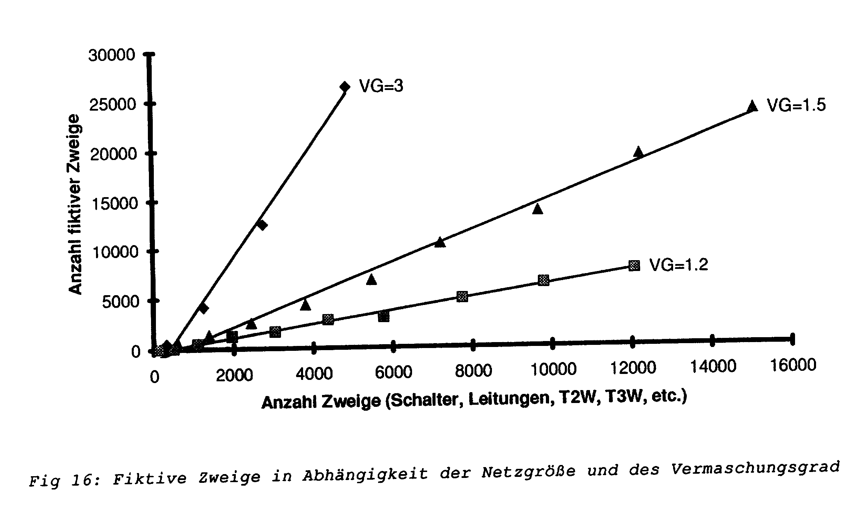

Wie oben beschrieben, wird die Terminal-Adjazenz-Matrix in eine obere Dreiecksmatrix transformiert. Hierbei werden fiktive Verbindungszweige *(Fill In)* erzeugt. Die Anzahl zusätzlicher Verbindungszweige ist abhängig von der Reihenfolge der einzelnen Transformationsschritte und vom Vermaschungsgrad VG. Beim Aufbau der oberen Dreiecksmatrix wird die Reihenfolge der Transformationsschritte optimiert. Deshalb reduziert sich die Abhängigkeit auf den Vermaschungsgrad und die Anzahl Zweige, wie im **Fig. 16** dargestellt. Die Anzahl fiktiver Zweige beeinflußt die Performance des vorgeschlagenen Verfahrens. Die weiteren Diagramme für die einzelnen Programmschritte zeigen dies deutlich.

### 6.2. Performance der einzelnen Programmschritte über die Netzgröße in Abhängigkeit vom Vermaschungsgrad

Die CPU-Zeit eines 80486 40MHz Rechners wurde für folgende Programmschritte in Abhängigkeit der Anzahl Zweige und des Vermaschungsgrades gemessen

1. Aufbau der statischen Topologiestruktur *Parkett[]*
2. Initialisierung der dynamischen Topologie auf Basis der aktuellen Status aller Netzzweige
3. Update der dynamischen Topologie aufgrund einer Statusänderung eines Zweiges

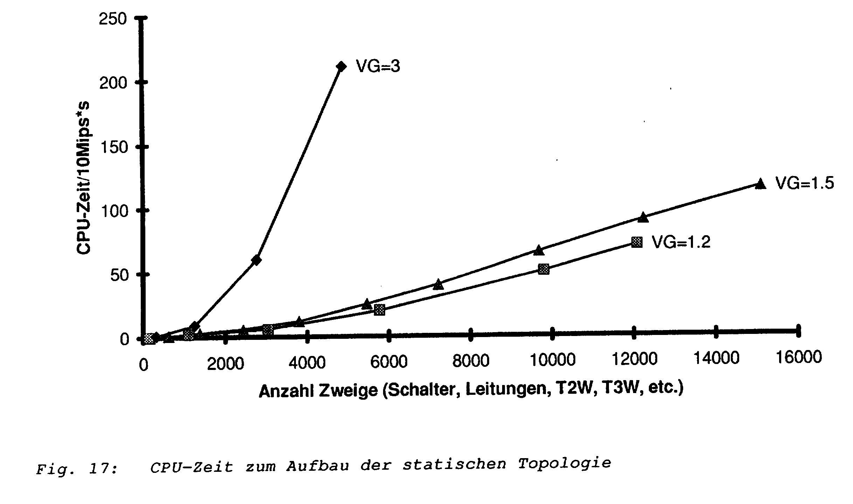

**Fig. 17** zeigt die benötigte CPU-Zeit in 10 Mips*s für den Aufbau der statischen Topologie *Parkett[]*. Die Zeit für eine 100 Mips CPU ergibt sich dann durch Division mit 100 Mips.

Der Aufbau dieser Struktur *Parkett[]* ist der aufwendigste der 3 Verarbeitungsschritte. Ein Aufbau dieser Struktur ist allerdings nur bei Netzausbau notwendig. Legt man eine 200 Mips CPU (z.B. DEC AXP 600) zugrunde, so benötigt man für ein Netz ähnlicher Größe wie das unter Punkt 5 beschriebene Testnetz ca. 3s CPU-Zeit.

Die Größe der Struktur *Parkett[]* wird folgendermaßen berechnet:

$$(2*\text{Anzahl Zweige} + \text{Anzahl Terminals})*16 \text{ Byte}$$

Für ein Netz in der Größenordnung des Testnetzes ergibt sich die Größe von *Parkett[]* zu ca. 0.6 MByte.

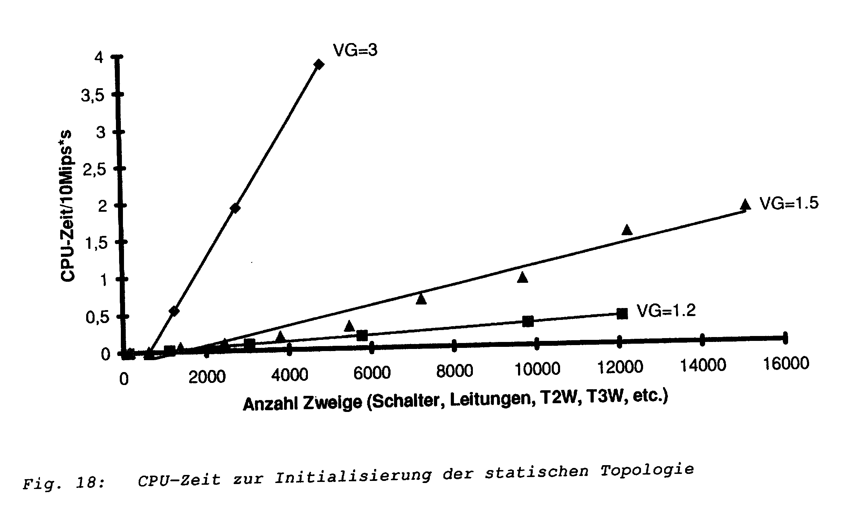

**Fig. 18** zeigt die benötigte CPU-Zeit in 10 Mips*s für die Initialisierung der statischen Topologie *Parkett[]* mit den aktuellen Status aller Netzzweige:

Eine Initialisierung der Topologie ist typischerweise beim Systemstart, nach Datenänderungen und je nach Doppelrechner-Philosophie beim Rechnerwechsel notwendig. Für ein Netz in der Größenordnung des Testnetzes wäre die Initialisierung auf einer 200 Mips CPU in ca. 25 Millisekunden CPU-Zeit abgeschlossen.

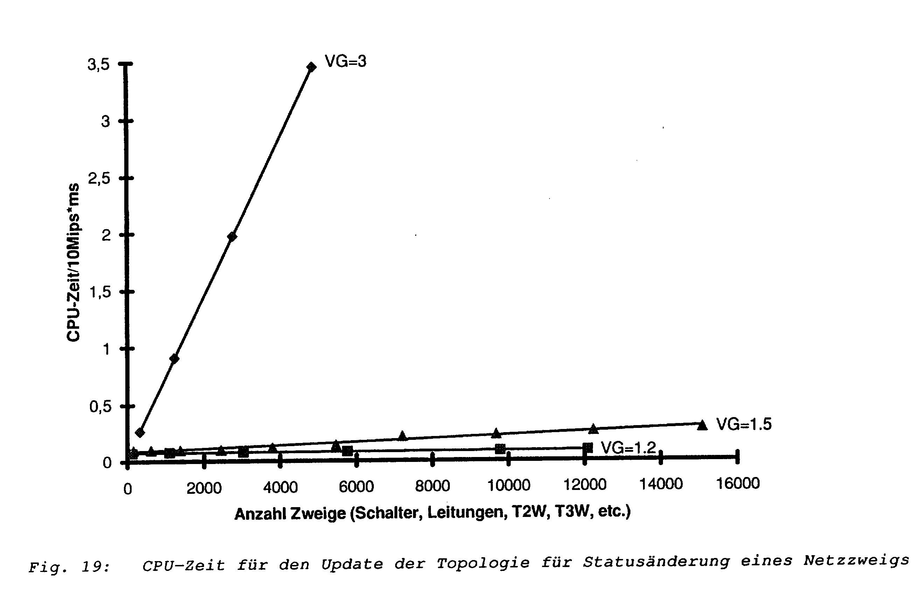

**Fig. 19** zeigt die benötigte CPU-Zeit in 10 Mips*ms für den Update der Topologie *Parkett[]* mit dem aktuellen Status eines Netzzweigs:

Die mittlere Zeit für einen Update der Topologiestruktur bei einer Statusänderung z.B. eines Schalters beträgt für ein Netz in der Größenordnung des Testnetzes für eine 80486 CPU mit 40MHz ca. **8.0 $10^{-5}$ s.** Für eine 200 Mips CPU liegt sie in der Größenordnung von ca. **4.0 $10^{-6}$ s.**v Diese Zeit ist um mehrere Größenordnungen schneller, als die Zeiten der momentan eingesetzten und bekannten Verfahren. Hierdurch sind gänzlich neue Konzepte bei der Topologieverarbeitung sowie bei den anschließenden Berechnungsverfahren möglich. Zum Beispiel können alle Zweige des Netzes nach jedem Update darauf untersucht werden, ob der jeweilige Zweig die einzige Verbindung (kritischer Zweig) zwischen zwei Teilnetzen ist. Für ein Netz in der Größenordnung des Testnetzes und eine 200 Mips CPU würde die CPU-Gesamtzeit inclusive Update ca.

$$2*\text{Anzahl Zweige } *T_{update} \approx 100 \text{ Millisekunden}$$

dauern. Weiterhin zeigt dieses Beispiel, daß die kumulierte CPU-Zeit für die Ausführung von Updates für alle Schalter in diesem Beispiel ca. 50 Millisekunden beträgt. Dies ist nur etwa die doppelte Zeit, die die Initialisierung benötigt und ein weiterer Hinweis, daß der Update bei diesem Verfahren nur die wirklich notwendigen Änderungen der Datenstruktur umfaßt.

**Patentansprüche**

1. Verfahren zur Initialisierung und Aktualisierung eines Netzmodells, wobei die Netztopologie in Form eines Netzgraphen unter Anwendung und Erweiterung von Sparse-Vector-Verfahren und Sparse-Matrix-Verfahren durch nachstehende Schritte gebildet wird:

    a) Bereitstellung erfaßter Netztopologiedaten in Form einer Terminal-Adjazenz-Matrix;
    b) Umformung der Terminal-Adjazenz-Matrix in eine obere Dreiecksmatrix, wobei zusätzliche fiktive Verbindungszweige entstehen können;
    c) Initialisierung der oberen Dreiecksmatrix, wobei jedes Element der oberen Dreiecksmatrix aufgrund des zugehörigen Zweigstatus initialisiert wird, und wobei

        c1) jede zu einem eingeschalteten Zweig gehörendes Element mit einer kleinen negativen ganzzahligen Konstante K initialisiert wird, die so gewählt ist, daß sie durch die weiteren Verarbeitungsschritte nicht größer als Null werden kann, und
        c2) jede zu einem ausgeschalteten oder fiktiven Zweig gehörendes Element mit Null initialisiert wird,

    d) Bildung der Matrixprodukte für alle Zeilen i (i = 1 bis maximale Anzahl der Zeilen), der oberen Dreiecksmatrix ab und ausschließlich der Diagonalen nach folgender Regel: falls die Elemente i,j und i,k ungleich Null sind, sind die Elemente aller Schnittpunkte des Zeilen- und Spalten-Bruchstückes der oberen Dreiecksmatrix um 1 zu inkrementieren, wobei j und k Laufindizes für alle Elemente der betreffenden Zeile sind;
    e) Bildung einer Pfad-Tabelle aus der oberen Dreiecksmatrix, wobei die Pfad-Tabelle für jede Zeile bzw. jedes Terminal der oberen Dreiecksmatrix den inzidenten Terminal-Index des ersten von Null verschiedenen Elementes dieser Zeile angibt;

f) Aktualisierung der oberen Dreiecksmatrix im Fall einer Änderung der erfaßten Netztopologiedaten, also einer Statusänderung eines Netzzweiges, durch folgende Maßnahmen:

f1) im Fall einer Ausschaltung eines Netzzweiges: vom entsprechenden aktuellen (= bisherigen) Wert des Matrixelementes wird die Konstante K subtrahiert;

f11) falls dieses Element dadurch zu Null wird, sind die Elemente aller Schnittpunkte der oberen Dreiecksmatrix dieses Zeilen- und Spalten-Elementes mit allen anderen Elementen ungleich Null der zugehörigen Zeile bzw. Spalte, rechts bzw. unterhalb der Diagonalen um 1 zu dekrementieren; falls dadurch weitere Elemente zu Null werden, wird für diese die Operation in f11) wiederholt;

f2) im Fall des Einschaltens eines Netzzweiges: zum aktuellen Wert des Matrixelementes wird die Konstante K addiert;

f21) falls dieses Element dadurch zu K oder für weitere Wiederholungen zu 1 wird, sind die Elemente aller Schnittpunkte der oberen Dreiecksmatrix dieses Zeilen- und Spalten-Elementes mit allen anderen Elementen ungleich Null der zugehörigen Zeile bzw. Spalte, rechts bzw. unterhalb der Diagonalen um 1 zu inkrementieren; falls dadurch Elemente zu Eins werden, wird für diese die Operation in f21) wiederholt;

g) Aktualisierung der Pfad-Tabelle entsprechend dem Schritt e);

h) Kennzeichnung der Komponenten des Netzgraphen anhand der Pfad-Tabelle, wobei ausgehend vom ersten Terminal-Index der Tabelle allen Terminals des zugehörigen Teil-Pfades die gleiche Komponenten-Kennzeichnung zugeordnet wird; ergibt sich beim Durchlaufen weiterer Teil-Pfade eine schon vergebene Kennzeichnung (durch Treffen auf eine Komponente, der schon eine Kennzeichnung zugeordnet ist), so wird diese Kennzeichnung dem gerade durchlaufenen Teil-Pfad zugeordnet; der Netzgraph zerfällt in Teil-Graphen entsprechend der Anzahl vergebener Kennzeichnungen.

2. Verfahren nach Anspruch 1, dadurch gekennzeichnet, daß die Konstante K eine ausreichend große positive Zahl ist, und anstatt Dekrement- Inkrementoperationen und umgekehrt auf die Matrixelemente ausgeführt werden.

3. Verfahren nach Anspruch 1 oder 2, dadurch gekennzeichnet, daß zur Bereitstellung der Netztopologiedaten in einer zweckmäßigen Datenstruktur interne und externe topologische Adressen verwendet werden, wobei ausgehend von einer definierten topologischen Hierarchie jede Hierarchiestufe mit einem Identifizierer bezeichnet wird, und in einer externen topologischen Adresse eines Terminals (niedrigste Hierarchiestufe) die Zugehörigkeit zu bestimmten Komponenten der höheren Hierarchiestufen enthalten ist, woraus die abstrakten Endpunkte des Netzgraphen als interne topologische Adressen ableitbar sind.

4. Verfahren nach Anspruch 3, dadurch gekennzeichnet, daß Meßwerte und Schutzmeldungen topologisch zugeordnet werden, wobei im Fall des Modells eines elektrischen Netzes Leistungsmeßwerte als gerichtete impedanzlose Zweige und Spannungsmeßwerte als Objekte mit einer externen topologischen Adresse modelliert werden.

**Claims**

1. Method of initializing and updating a network model, the network topology being formed in the form of a network graph by applying and extending sparse vector methods and sparse matrix methods by the following steps:

a) preparing captured network topology data in the form of a terminal adjacence matrix;

b) transforming the terminal adjacence matrix into an upper triangular matrix, additional fictitious connecting branches possibly being produced;

c) initializing the upper triangular matrix, each element of the upper triangular matrix being initialized on the basis of the associated branch status, and

c1) each element belonging to a switched-on branch being initialized with a small negative integer constant K, which is chosen such that it cannot become greater than zero through the further processing steps, and

c2) each element belonging to a switched-off or fictitious branch is initialized with zero,

d) forming the matrix products for all the rows i (i = 1 up to the maximum number of rows), of the upper triangular matrix as from and excluding the diagonal according to the following rule: if the elements i, j and i, k are not equal to zero, the elements of the points of intersection of the row and column fraction of the upper triangular matrix are to be incremented by 1, j and k being loop indices for all the elements of the row concerned;

e) forming a path table from the upper triangular matrix, the path table indicating for each row or each terminal of the upper triangular matrix the incident terminal index of the first element of this row differing from zero;

f) updating the upper triangular matrix in the case of a change to the captured network topology data, that is to say a change in status of a network branch, by the following measures:

f1) in the case of switching off a network branch: the constant K is subtracted from the corresponding current (= previous) value of the matrix element;

f11) if this element becomes zero as a result, the elements of all the points of intersection of the upper triangular matrix of this row and column element with all the other elements not equal to zero of the associated row or column, to the right of or beneath the diagonal, are to be decremented by 1; if, as a result, further elements become zero, the operation in f11) is repeated for these;

f2) in the case of switching on a network branch: the constant K is added to the current value of the matrix element;

f21) if this element becomes K or, for further repetitions, becomes 1 as a result, the elements of all the points of intersection of the upper triangular matrix of this row and column element with all the other elements not equal to zero of the associated row or column, to the right of or beneath the diagonal, are to be incremented by 1; if, as a result, elements become 1, the operation in f21) is repeated for these;

g) updating the path table in accordance with the step e);

h) identifying the components of the network graph using the path table, the first terminal index of the table being taken as a basis for assigning the same component identification to all the terminals of the associated subpath; if an already allocated identification occurs when running through further subpaths (due to encountering a component which has already been assigned an identification), this identification is assigned to the subpath being run through at that time; the network graph breaks down into subgraphs in a manner corresponding to the number of identifications allocated.

2. Method according to Claim 1, characterized in that the constant K is an adequately large positive number, and instead of decrementing operations incrementing operations, and vice versa, are executed on the matrix elements.

3. Method according to Claim 1 or 2, characterized in that, for preparing the network topology data in an expedient data structure, internal and external topological addresses are used, a defined topological hierarchy being taken as a basis for designating each hierarchical stage with an identifier, and the association with certain components of the higher hierarchical stages being contained in an external topological address of a terminal (lowest hierarchical stage), from which association the abstract end points of the network graph can be derived as internal topological addresses.

4. Method according to Claim 3, characterized in that measured values and protection signals are topologically assigned, it being provided in the case of the model of an electrical network that measured performance values are modelled as directed impedanceless branches and measured voltage values are modelled as objects with an external topological address.

**Revendications**

1. Procédé d'initialisation et de mise à jour d'un modèle de réseau, la topologie du réseau, sous la forme d'un graphe de réseau, étant obtenue en appliquant et en complétant des méthodes "sparse vector" et "sparse matrix" par les étapes de procédé suivantes:

a) présentation de données de topologie de réseau mesurées sous la forme d'une matrice adjacente de borne;

b) transformation de la matrice adjacente de borne en une matrice triangulaire supérieure, des branches de liaison fictives supplémentaires pouvant être formées;

c) initialisation de la matrice triangulaire supérieure, chaque élément de la matrice triangulaire supérieure étant initialisé sur la base du statut de branche correspondant et

c1) chaque élément qui appartient à une branche en service étant initialisé avec une constante entière K négative de faible valeur choisie telle qu'elle ne puisse pas devenir supérieure à zéro avec les pas de traitement supplémentaires, et

c2) chaque élément qui appartient à une branche hors service ou fictive étant initialisé avec la valeur zéro

d) formation des produits matriciels pour toutes les lignes i(i=1 jusqu'au nombre maximal de lignes) de la matrice triangulaire supérieure ab et exclusivement des diagonales conformément à la règle suivante: si les éléments i,j et i,k sont différents de zéro, incrémenter de 1 les éléments de tous les points d'intersection du fragment de ligne et de colonne, j et k étant des indices de rang pour tous les éléments de la ligne concernée;

e) formation d'un tableau de chemin à partir de la matrice triangulaire supérieure, le tableau de chemin indiquant pour chaque ligne ou pour chaque borne de la matrice triangulaire supérieure, l'indice de borne incident du premier élément différent de zéro dans cette ligne;

f) mise à jour de la matrice triangulaire supérieure dans le cas d'un changement d'état des données de topologie de réseau mesurées, c'est-à-dire de changement d'état d'une branche de réseau, par les dispositions suivantes:

f1) en cas de coupure d'une branche de réseau: on soustrait la constante K de la valeur actuelle correspondante (=valeur jusqu'à cet instant) de l'élément de matrice;

f11) si cet élément devient nul, on décrémente de 1 les éléments de tous les points d'intersection de la matrice triangulaire supérieure de cet élément de lignes et de colonnes ainsi que tous les autres éléments différents de zéro de la ligne ou de la colonne concernée, à droite ou en-dessous de la diagonale;

si d'autres éléments deviennent nuls, on répète l'opération sous f11) pour lesdits éléments;

f2) en cas de mise en service d'une branche de réseau: on ajoute la constante K à la valeur actuelle de l'élément de matrice;

f21) si cet élément prend la valeur K ou la valeur 1 pour des d'autres passages, on incrémente de 1 les éléments de tous les points d'intersection de la matrice triangulaire supérieure de cet élément de lignes et de colonnes ainsi que tous les autres éléments différents de zéro de la ligne ou de la ligne concernée, à droite ou en-dessous de la diagonale;

si d'autres éléments prennent la valeur un, on répète l'opération sous f21) pour lesdits éléments;

g) mise à jour du tableau de chemin en accord avec l'étape e)

h) identification des composants du graphes de réseau à l'aide du tableau de chemin, le même identificateur de composant étant attribué à toutes les bornes de chemin élémentaire concerné en partant du premier indice de borne du tableau; si en parcourant d'autres chemins élémentaires on note qu'un identificateur a déjà été attribué (rencontre d'un composant auquel un identificateur est déjà associé), cet identificateur est associé au chemin élémentaire déjà parcouru; le graphe de réseau se décompose en graphes élémentaires en fonction du nombre d'identificateurs attribués.

2. Procédé selon la revendication 1, caractérisé par le fait que la constante K est un nombre positif suffisamment grand et que l'on exécute sur les éléments de matrice des opérations de décrémentation à la place d'opération d'incrémentation et inversement.

3. Procédé selon la revendication 1 ou 2, caractérisé par le fait que pour stocker les données de topologie de réseau dans une structure de données adaptée, on utilise des adresse topologiques internes et externes, partant d'une hiérarchie topologique déterminée, chaque niveau hiérarchique étant caractérisé par un identificateur et l'appartenance à certains composants de niveaux hiérarchiques supérieurs étant incluse dans une adresse topologique externe d'une borne (plus bas niveau hiérarchique) ce qui permet d'en déduire les points d'extrémité abstraits du graphe de réseau en tant qu'adresse topologique interne.

4. Procédé selon la revendication 3, caractérisé par le fait que l'on associe topologiquement des valeurs de mesure et des messages de sécurité, dans le cas d'un modèle de réseau électrique des valeurs de mesure de puissance étant modélisées en tant que branches sans impédance orientées et des valeurs de mesure de tension étant modélisées en tant qu'objets avec une adresse topologique externe.

# Station und EVU-Station

Fig. 1: Station/EVU-Station

EP 0 715 266 B1

# Feld und Terminal in der EVU-Station

**Sammelschienenfeld 1**

Fig. 2: Aufbau eines Feldes in einer EVU-Station

*Fig. 3: Transformation der externen in die interne topologische Adresse*

EP 0 715 266 B1

Fig. 4: Meßwertzuordnung

EP 0 715 266 B1

eingeschalteter Zweig

Terminal

D

A

2

8

1

b

c

e

f

G

H

K

7

6

5

ausgeschalteter Zweig

I

j

l

m

n

O

P

3

9

4

Fig. 5: Beispielgraph

strukturelle LDU-Zerlegung

Fig. 6: *Terminal-Adjazenz-Matrix und deren LDU-Zerlegung*

*Fig. 7: Initialisierung der Upper-Matrix*

EP 0 715 266 B1

| | 1 | 2 | 3 | 4 | 5 | 6 | 7 | 8 | 9 |
|---|---|---|---|---|---|---|---|---|---|
| 1 | • | | | | G | | | D | |
| 2 | | • | | | | c | b | A | |
| 3 | | | • | | | | I | | O |
| 4 | | | | • | n | m | | | P |
| 5 | | | | | • | K | | f | Δ |
| 6 | | | | | | • | H | e | I |
| 7 | | | | | | | • | Δ | j |
| 8 | | | | | | | | • | Δ |
| 9 | | | | | | | | | • |

*Zweigbezeichner*

Zweigstatus →

| | 1 | 2 | 3 | 4 | 5 | 6 | 7 | 8 | 9 |
|---|---|---|---|---|---|---|---|---|---|
| 1 | 1 | | | | −128 | | | −128 | |
| 2 | | 1 | | | | 0 | 0 | −128 | |
| 3 | | | 1 | | | | −128 | | −128 |
| 4 | | | | 1 | 0 | 0 | | | −128 |
| 5 | | | | | 2 | −128 | | 1 | 0 |
| 6 | | | | | | 2 | −128 | 1 | 0 |
| 7 | | | | | | | 3 | 1 | 1 |
| 8 | | | | | | | | 6 | 1 |
| 9 | | | | | | | | | 5 |

*Zahlenwerte der Upper - Matrixelemente*

*Fig. 8: Ganzzahlig initialisierte Upper-Matrix Parkett[]*

EP 0 715 266 B1

| Terminal | erste besetzte Spalte in Parkett[] |
|---|---|
| 1 | 5 |
| 2 | 8 |
| 3 | 7 |
| 4 | 9 |
| 5 | 6 |
| 6 | 7 |
| 7 | 8 |
| 8 | 9 |
| 9 | 0 |

Fig. 9: Inhalt der Struktur PathTable[] und der Path Graph für obigen Beispielgraph

**Initialisierung:**

$$u_{ik}^{j} = u_{ik}^{j-1} + \delta(u_{j-1,k}^{j-1}, u_{i,j-1}^{j-1})$$

$$\delta = 1 \quad \text{Falls } u_{jk}^{j-1} \wedge u_{ij}^{j-1} \neq 0$$

$$\delta = 0 \quad \text{sonst}$$

$$j = 2(1)n - 1, \, i = j + 1(1)n, \; k = j(1)n$$

$$n = \text{Anzahl Terminals}$$

**Update:**

$$u_{l,k}^{neu} = u_{l,k}^{alt} \pm K \qquad\qquad A$$

Falls $u_{l,k}^{neu} = K$ (Einschalten)

Falls $u_{l,k}^{neu} = 0$ (Ausschalten)

- - - - - - - - - - - - - - - - - - - - - - - - - - - - - - -

$$u_{z,k}^{neu} = u_{z,k}^{alt} + \delta(u_{z,l}) \qquad B$$

$$\delta = \pm 1 \quad \text{falls } u_{z,l} \neq 0$$

$$\delta = 0 \quad \text{sonst}$$

$$z = i + 1, (1), k$$

$$u_{k,s}^{neu} = u_{k,s}^{alt} + \delta(u_{l,s})$$

$$\delta = \pm 1 \quad \text{falls } u_{l,s} \neq 0 \vee s = k$$

$$\delta = 0 \quad \text{sonst}$$

$$s = k, (1), n$$

$$n = \text{Anzahl Terminals}$$

Für alle

$$u_{z,k}^{neu} = 1 \text{ (Einschalten)}$$

$$u_{k,s}^{neu} = 1 \text{ (Einschalten)}$$

$$u_{z,k}^{neu} = 0 \text{ (Ausschalten)}$$

$$u_{k,s}^{neu} = 0 \text{ (Ausschalten)}$$

muß Teil B nochmals durchgeführt werden

*Fig. 10: Mathematische Formulierung von Initialisierung und Update*

EP 0 715 266 B1

**Zweigbezeichner**

| | 1 | 2 | 3 | 4 | 5 | 6 | 7 | 8 | 9 |
|---|---|---|---|---|---|---|---|---|---|
| 1 | • | | | | | | | | |
| 2 | | • | | | G⟹g | c | b | D | |
| 3 | | | • | | | | I | A | O |
| 4 | | | | • | n | m | | | P |
| 5 | | | | | • | K | | f⟹f | Δ |
| 6 | | | | | | • | H | e⟹e | — |
| 7 | | | | | | | • | Δ⟹Δ | j |
| 8 | | | | | | | | • | Δ⟹Δ |
| 9 | | | | | | | | | • |

Zweigstatus →

**Zahlenwerte der Upper - Matrixelemente**

| | 1 | 2 | 3 | 4 | 5 | 6 | 7 | 8 | 9 |
|---|---|---|---|---|---|---|---|---|---|
| 1 | 1 | | | | ⟹0 | | | -128 | |
| 2 | | | 1 | | | 0 | 0 | 0 | -128 |
| 3 | | | | 1 | | | -128 | -128 | |
| 4 | | | | | 1 | 0 | 0 | | -128 |
| 5 | | | | | | ⟹1 | -128 | ⟹0 | 0 |
| 6 | | | | | | | 2 | -128 | ⟹0 |
| 7 | | | | | | | | 3 | ⟹0 |
| 8 | | | | | | | | ⟹3 | ⟹0 |
| 9 | | | | | | | | | ⟹4 |

*Fig. 11: Ganzzahlig aktualisierte Upper-Matrix Parkett[]*

25

| Terminal | erste besetzte Spalte in asParkett[] |
|---|---|
| 1 | 8 |
| 2 | 8 |
| 3 | 7 |
| 4 | 9 |
| 5 | 6 |
| 6 | 7 |
| 7 | 9 |
| 8 | 0 |
| 9 | 0 |

*Fig. 12: Inhalt der Struktur PathTable[] und der Path Graph für obigen modifizierten Beispielgraphen*

*Fig. 13: Knoten-Zweig-Netz*

EP 0 715 266 B1

Fig. 14: Ableitung der Knoten-Admittanz-Matrix

Fig. 15: Testgraphen für Performancemessungen

*Fig 16: Fiktive Zweige in Abhängigkeit der Netzgröße und des Vermaschungsgrad*

EP 0 715 266 B1

*Fig. 17:* *CPU-Zeit zum Aufbau der statischen Topologie*

*Fig. 18:* CPU-Zeit zur Initialisierung der statischen Topologie

EP 0 715 266 B1

Fig. 19: CPU-Zeit für den Update der Topologie für Statusänderung eines Netzzweigs